# EUROPÄISCHE PATENTANMELDUNG

(11) **EP 4 040 506 A1**
(43) Veröffentlichungstag der Anmeldung: **10.08.2022**
(21) Anmeldenummer: 22000024.4
(22) Anmeldetag: 01.02.2022
(51) Int. Cl.: H01L 29/861, H01L 29/20, H01L 29/207

(54) **STAPELFÖRMIGE III-V-HALBLEITERDIODE**

(30) Priorität: 08.02.2021 DE 102021000610
(71) Anmelder: 3-5 Power Electronics GmbH, 01217 Dresden (DE); AZUR SPACE Solar Power GmbH, 74072 Heilbronn (DE)
(72) Erfinder: Dudek, Volker, 76275 Ettlingen (DE); Kowalsky, Jens, 15859 Storkow (DE); Bhojani, Riteshkumar, 09126 Chemnitz (DE); Fuhrmann, Daniel, 74081 Heilbronn (DE); Wierzkowski, Thorsten, 74074 Heilbronn (DE)
(74) Vertreter: Koch Müller Patentanwaltsgesellschaft mbH

(57) **Zusammenfassung**

Stapelförmige III-V-Halbleiterdiode umfassend oder bestehend aus GaAs, aufweisend eine hoch n-dotierte Kathodenschicht, eine hoch p-dotierte Anodenschicht und ein zwischen der Kathodenschicht und der Anodenschicht angeordnetes Driftgebiet mit einer Dotierstoffkonzentration von höchstens 8•10¹⁵ cm⁻³ und einer Schichtdicke von mindestens 10 µm, wobei die Kathodenschicht einen Deltaschichtabschnitt mit einer Schichtdicke von 0,1 µm bis 2 µm und einer Dotierstoffkonzentration von mindestens 1•10¹⁹ cm⁻³ aufweist.

## Beschreibung

Die Erfindung betrifft eine stapelförmige III-V-Halbleiterdiode umfassend oder bestehend aus GaAs mit einer hoch n-dotierten Kathodenschicht, einer hoch p-dotierten Anodenschicht und einem zwischen der Kathodenschicht und der Anodenschicht angeordneten Driftgebiet.

Eine hochspannungsfeste Halbleiterdiode mit einer p⁺ - n - n⁺ Struktur aus Galliumarsenid ist aus "GaAs Power Devices" von German Ashkinazi, ISBN 965-7094-19-4, Seite 8 und 9 bekannt.

Weitere stapelförmige III-V-Halbleiterdioden sind aus der EP 3 321 971 B1 sowie aus der EP 3 321 970 B1 bekannt, wobei die Halbleiterdioden eine zusätzliche Zwischenschicht zwischen dem Driftgebiet und der Kathode bzw. Anode aufweisen.

Vor diesem Hintergrund besteht die Aufgabe der Erfindung darin, eine Vorrichtung anzugeben, die den Stand der Technik weiterbildet.

Die Aufgabe wird durch eine stapelförmige III-V-Halbleiterdiode mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige III-V-Halbleiterdiode umfassend oder bestehend aus GaAs bereitgestellt, aufweisend eine hoch n-dotierte Kathodenschicht, eine hoch p-dotierte Anodenschicht.

Zwischen der Kathodenschicht und der Anodenschicht ist ein Driftgebiet mit einer Dotierstoffkonzentration von höchstens 8●10¹⁵ cm⁻³ und einer Schichtdicke von mindestens 10 µm angeordnet. Vorzugsweise beträgt die gesamte Schichtdicke des Driftgebiets maximal 50 µm oder maximal 100 µm.

Die Kathodenschicht weist einen ersten Abschnitt und einen zweiten Abschnitt auf.

Der erste Abschnitt ist als ein Deltaschichtabschnitt mit einer Schichtdicke zwischen 0,1 µm bis 1 µm oder zwischen 0,1 µm bis 2 µm ausgebildet.

Der Deltaschichtabschnitt weist eine Dotierstoffkonzentration von mindestens 1●10¹⁹ cm⁻³ oder von mindestens 2●10¹⁹ cm⁻³ auf.

Es versteht sich, dass alle Halbleiterschichten einer aus GaAs bestehenden oder GaAs umfassenden Halbleiterdiode, also insbesondere die Kathodenschicht, die Anodenschicht und das Driftgebiet, jeweils aus GaAs bestehen oder GaAs zumindest umfassen. Anders ausgedrückt jede Halbleiterschicht der III-V-Halbleiterdiode weist mindestens die Elemente Ga und As auf.

Des Weiteren versteht es sich, dass innerhalb des Driftgebietes ein pn Übergang ausbildet ist.

Es sei angemerkt, dass die Halbleiterschichten der Halleiterdiode stapelförmig aufeinander ausgebildet sind. Vorzugsweise weisen die Halbleiterschichten die gleiche Fläche auf. Vorzugsweise ist eine der Halbleiterschichten als Substratschicht ausgebildet oder umfasst eine Substratschicht. In einer Weiterbildung weist die Substratschicht eine größere Fläche als die auf der Substratschicht angeordnete Stapel der Halbleiterschichten auf.

Vorzugsweise umfasst die Substratschicht eine Dicke zwischen 50 µm und 120 µm oder zwischen 50 µm und 250 µm. In einer Weiterbildung weist die Substratschicht im Falle einer p-Dotierung eine Konzentration in einem Bereich zwischen 1●10¹⁷ cm⁻³ bis zu 2●10¹⁸ cm⁻³ oder bis zu 8●10¹⁸ cm⁻³ auf Die Halbleiterschichten sind bevorzugt epitaktisch aufeinander erzeugt. Besonders bevorzugt wird die Kathodenschicht oder die Anodenschicht durch eine Substratschicht ausgebildet, auf der alle weiteren Halbleiterschichten nacheinander epitaktisch gewachsen werden. Alternativ werden Schichten mittels eines Waferbonds verbunden.

Außerdem versteht es sich, dass die Halbleiterdiode vorzugsweise weitere Schichten aus anderen Materialien, insbesondere metallische Anschlusskontaktschichten, aufweist.

Des Weiteren sei angemerkt, dass der Begriff der Anode mit dem Begriff Andenschicht und der Begriff der Kathode mit dem Begriff der Kathodenschicht jeweils synonym verwendet werden.

Die Anschlusskontaktschichten bestehen beispielsweise vollständig oder teilweise aus einem Metall, z.B. Gold, oder aus einer Metalllegierung und sind beispielsweise mittels Elektronenstrahlverdampfung oder mittels Sputterns erzeugt.

Der an eine Anschlusskontaktschicht angrenzende Bereich der Kathodenschicht sowie der Anodenschicht weist bevorzugt eine höhere Dotierstoffkonzentration als der jeweilige weitere Teil der Kathodenschicht sowie der Anodenschicht auf, um einen möglichst niederohmigen elektrischen Kontakt auszubilden und den Serienwiderstand bzw. die Verlustleistung der Halbleiterdiode so gering wie möglich zu halten.

Zumindest über eine verhältnismäßig geringe Dicke, d.h. vorzugsweise weniger als 1 µm ist es möglich, in GaAs-Schichten oder GaAs-basierten Schichten eine sehr hohe Dotierung, insbesondere eine Dotierung von mindestens 1●10¹⁹ cm⁻³ mit einer guten Schichtqualität herzustellen. Geeignete Dotierstoffe insbesondere für die Kathodenschicht sind hierfür sind beispielswelse Tellur oder Selen.

Entsprechend richtet sich die Schichtdicke des zweiten Abschnitts der Kathodenschicht im Wesentlichen nach der Lebensdauer bzw. der Eindringtiefe der Minoritätsladungsträger, d. h. der Löcher. Typischerweise reicht als Schichtdicke der zweiten Schicht einige Hundert Nanometer bis maximal 2 µm aus.

Anders ausgedrückt, die Dicke des zweiten Abschnitts der Kathodenschicht ist vorzugsweise so dick wie die freie Weglänge der Minoritätsladungsträger d.h. der Löcher in der Kathode ist.

Des Weiteren bildet der Deltaschichtabschnitt quasi eine Barriere für die Minoritätsladungsträger und reduziert den Anschlusswiderstand. Durch den Deltaschichtabschnitt werden insbesondere das Abschaltverhalten und hierdurch das Schaltverhalten der Diode verbessert.

Untersuchungen haben gezeigt, dass sich aus einer Kombination von einem dünnen jedoch sehr hochdotierten Deltaschichtabschnitt und einem zweiten niedriger dotierten Abschnitt der Kathodenschicht die Emittereffizienz, d.h. die Effizienz der Kathode verbessern lässt.

In Kombination mit dem niedrig dotierten Driftgebiet lassen sich Dioden mit besonders hohen Sperrspannungen von über 1100 V oder sogar über 1200 V, kleinen Einschaltwiderständen sowie besonders geringen Kapazitäten pro Fläche herstellen.

In einer Ausführungsform weist die Kathodenschicht einen zweiten Schichtabschnitt mit einer geringeren Dotierstoffkonzentration als der Dotierstoffkonzentration des Deltaschichtabschnitts auf, so dass der Deltaschichtabschnitt eine typische Kathodenschicht quasi durch einen Delta-Dotierungspeak ergänzt.

Vorzugsweise weist der Deltaschichtabschnitt eine stoffschlüssige Verbindung mit einem zweiten metallischen Anschlusskontakt auf. Anders ausgedrückt der metallische Anschlusskontakt ist auf einer Oberseite der Kathodenschicht angeordnet.

Auf einer Unterseite der Anodenschicht ist ein erster metallischer Anschlusskontakt. Vorzugsweise überdecken die beiden metallischen Anschlusskontakte die Anodenschicht und / oder die Kathodenschicht in einem zentralen Bereich oder nahezu vollständig oder vollständig, um einen niedrigen Anschlusswiderstand zu erreichen. Es versteht sich, dass auch bei einer vollständigen Überdeckung ein umlaufender Randabschnitt nicht metallisierst ist, um die Prozesssicherheit zu erhöhen.

In einer Weiterbildung weist der zweite Schichtabschnitt der Kathodenschicht eine geringere Dotierstoffkonzentration als der Deltaschichtabschnitt auf. Vorzugsweise weist der zweite Schichtabschnitt der Kathodenschicht eine größere Schichtdicke D_{K2} als der Deltaschichtabschnitt auf.

Vorzugsweise weist der zweite Schichtabschnitt der Kathodenschicht eine Dicke von mindestens 0,5 µm bis maximal 1,5 µm auf oder von mindestens 0,5 µm bis maximal 2,5 µm auf oder von mindestens 0,5 µm bis maximal 5 µm auf.

Es sei angemerkt, dass der Begriff Dotierung und der Begriff Dotierstoffkonzentration synonym verwendet werden. Des Weiteren sei angemerkt, dass die Änderung der Dotierung zwischen dem Deltaschichtanschnitt und dem zweiten Abschnitt der Kathodenschicht vorzugsweise sprunghaft erfolgt. Anders ausgedrückt, die Dotierung ändert sich vorzugsweise innerhalb eines Dickenbereichs von kleiner als 0,1 µm oder kleiner als 0,05 µm.

Die Dotierstoffkonzentration des zweiten Schichtabschnitts der Kathodenschicht liegt unterhalb von 1●10¹⁹ cm⁻³. Vorzugsweise liegt die Dotierstoffkonzentration des zweiten Schichtabschnitts der Kathodenschicht oberhalb von 1●10¹⁸ cm⁻³ oder von 2●10¹⁸ cm⁻³ oder von 5●10¹⁸ cm⁻³.

In einer Weiterbildung weist die Kathodenschicht einen Übergangsschichtabschnitt auf, wobei der Übergangsschichtabschnitt zwischen dem zweiten Abschnitt der Kathodenschicht und dem Driftgebiet angeordnet ist, eine Schichtdicke von mindestens 3 µm, eine geringere Dotierung als die Dotierung des zweiten Abschnitts, eine höhere Dotierung als die Driftgebiets und einen in Richtung des Driftgebiets konvex oder konkav oder linear oder treppenförmig abfallende Konzentrationsverlauf der Dotierung aufweist.

In einer weiteren Ausführungsform weist der Deltaschichtabschnitt Te und / oder Se als Dotierstoff auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Ansicht auf eine erste Ausführungsform einer stapelförmigen III-V-Halbleiterdiode,
- Figur 2: eine Ansicht auf eine erste Ausführungsform eines Dotierstoffkonzentrationsverlaufs der III-V-Halbleiterdiode,
- Figur 3: eine Ansicht auf eine weitere Ausführungsform der stapelförmigen III-V-Halbleiterdiode,
- Figur 4: eine Ansicht auf eine weitere Ausführungsform der stapelförmigen III-V-Halbleiterdiode,
- Figur 5: eine Ansicht auf eine weitere Ausführungsform der stapelförmigen III-V-Halbleiterdiode
- Figur 6: eine Ansicht einer weiteren Ausführungsform des Dotierstoffkonzentrationsverlaufs.

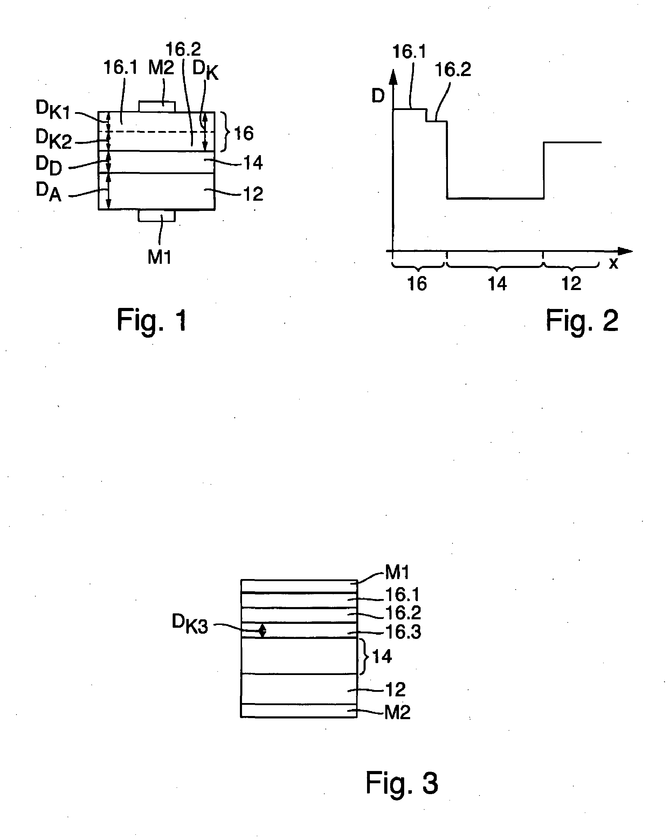

Die Abbildung der Figur 1 zeigt eine Ansicht auf eine erste Ausführungsform einer stapelförmigen III-V-Halbleiterdiode 10 aufweisend GaAs oder bestehend aus GaAs. Eine hochdotierte p-dotierte Substratschicht mit einer Gesamtdicke D_{A} bildet eine Anodenschicht 12 aus, auf der das Driftgebiet 14 mit einer Gesamtdicke D_{D} gefolgt von einer hoch n-dotierten Kathodenschicht 16 mit einer Schichtdicke D_{K} angeordnet ist.

Es versteht sich, dass innerhalb des Driftgebietes 14 ein pn Übergang ausbildet ist.

Die Kathodenschicht 16 weist einen ersten Abschnitt 16.1 und einen zweiten Abschnitt 16.2 auf.

Der erste Abschnitt 16.1 der Kathodenschicht 16 ist als ein Deltaschichtabschnitt ausgebildet mit einer sehr hohen Dotierstoffkonzentration von mindestens 1●10¹⁹ cm⁻³ oder mindestens 2●10¹⁹ cm⁻³ und einer geringen Schichtdicke D_{K1} von 0,1 µm bis 1 µm oder von 0,1 µm bis maximal 2 µm.

Der zweite Schichtabschnitt 16.2 weist eine geringere Dotierstoffkonzentration als der Deltaschichtabschnitt 16.1 und eine größere Schichtdicke D_{K2} auf.

Die Schichtdicke des zweiten Schichtabschnitts 16.2 der Kathodenschicht 16 weist eine Dicke in einem Bereich zwischen 0,5 µm bis 1,5 um oder in einem Bereich zwischen 0,5 µm bis 2,5 µm oder in einem Bereich zwischen 0,5 µm bis 5 µm auf.

Die Dotierstoffkonzentration des zweiten Schichtabschnitts 16.2 liegt unterhalb von 1●10¹⁹ cm⁻³. Vorzugsweise liegt die Dotierstoffkonzentration des zweiten Schichtabschnitts 16.2 oberhalb von 1●10¹⁸ cm⁻³ oder von 2●10¹⁸ cm⁻³ oder von 5●10¹⁸ cm⁻³.

Auf einer Unterseite der Anodenschicht 12 ist ein metallischer Anschlusskontakt M1 und auf einer Oberseite der Kathodenschicht 16 ist ein metallischer Anschlusskontakt M2 angeordnet.

Vorzugsweise überdecken die beiden metallischen Anschlusskontakte M1, M2 die Anodenschicht 12 und / oder die Kathodenschicht 16 nahezu vollständig, um einen niedrigen Anschlusswiderstand zu erreichen. Auch weist der Deltaschichtabschnitt 16.1 eine stoffschlüssige Verbindung mit dem metallischen Anschlusskontakt M2 auf.

In der Abbildung der Figur 2 ist ein Dotierstoffkonzentrationsverlauf entlang der Dicke der stapelförmigen III-V-Halbleiterdiode 10, dargestellt in Zusammenhang mit der Figur 1, abgebildet.

Aufgetragen ist die Dotierstoffkonzentration D über einer Position x entlang des Stapels der III-V-Halbleiterdiode 10.

Der Dotierstoffkonzentrationsverlauf. ist über die jeweilige Schichtdicke D_{K2} und D_{K1} der beiden Abschnitte 16.2 und 16.1 der Kathodenschicht 16 jeweils konstant ausgebildet, so dass sich ein Dotierstoffkonzentrationssprung zwischen dem zweiten Schichtabschnitt 16.2 und dem Deltaschichtabschnitt ausbildet.

Anschließend fällt die Dotierstoffkonzentration sprunghaft auf ein sehr niedriges Niveau im Bereich des Driftgebiets 14 von maximal 8●10⁻¹⁵ cm⁻³ ab. An dem Übergang des Driftgebiets 14 zu der Anodenschicht steigt die Dotierstoffkonzentration sprunghaft auf ein gleichmäßig hohes Niveau einer p-Dotierstoffkonzentration an.

Die Dotierstoffkonzentration entlang der Anode 12 ist konstant, wobei die Höhe der Dotierstoffkonzentration kleiner ist als die Dotierstoffkonzentration des zweiten Bereichs 16.2 der Kathode 16.

In dem dargestellten Ausführungsbeispiel weist das Driftgebiet eine niedrige und im Wesentlichen konstante Dotierstoffkonzentration auf. Hierbei wechselt die Dotierung entlang der gesamten Schichtdicke zwischen einem n-Dotierstoff oder einem p-Dotierstoff, so dass sich ein p-n Übergang in dem Driftgebiet 14 ausbildet.

In der in Figur 3 dargestellten Ausführungsform sind die metallischen Anschlusskontakte M1 und M2 flächig ausgebildet.

Die Kathodenschicht 16 weist zusätzlich zu dem ersten Abschnitt 16.1 und dem zweiten Abschnitt 16.2 einen Übergangsschichtabschnitt 16.3 auf. Der Übergangsschichtabschnitt 16.3 weist eine Schichtdicke D_{K3} von mindestens 3 µm und beispielsweise höchstens 10 µm oder höchstens 5 µm auf.

Der Übergangsschichtabschnitt 16.3 der Kathodenschicht 16 weist eine geringere Dotierung als die Dotierung des zweiten Abschnitts 16.2 der Kathodenschicht 16 und eine höhere Dotierung als die Driftgebiets 14 auf.

Der innerhalb des Übergangsschichtabschnitts 16.3 abfallende Konzentrationsverlauf der Dotierung in Richtung des Driftgebiets 14 ist konvex oder konkav oder linear oder treppenförmig ausgebildet.

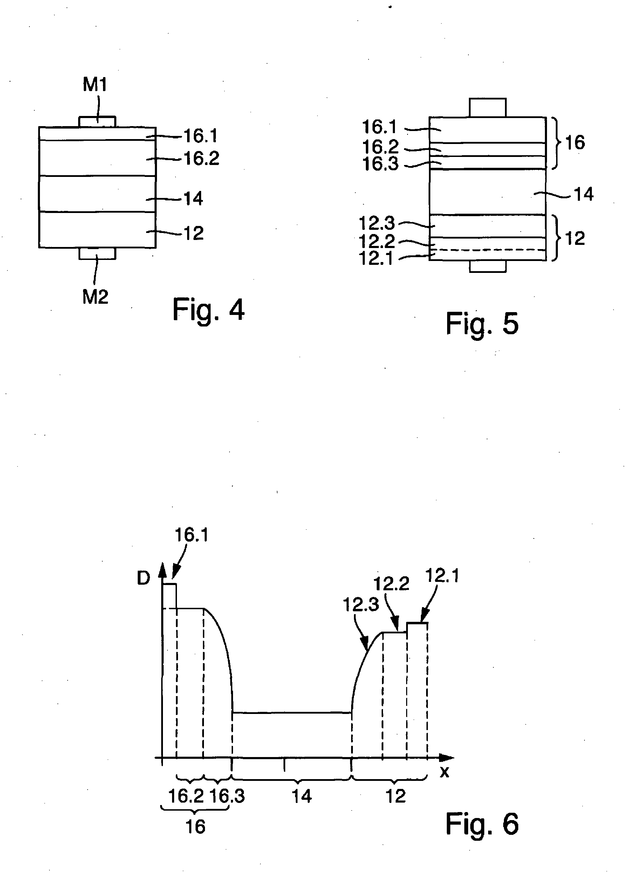

In dem Ausführungsbeispiel der Figur 4 bedecken die beiden metallischen Kontaktschichten M1, M2 jeweils nur einen zentralen Teil der Anode bzw. der Kathode. Der Übergangsschichtabschnitt 16.3 ist nicht ausgebildet, so dass der zweite Abschnitt 16.2 der Kathode unmittelbar an das Driftgebiet 14 anschließt.

In dem in Figur 5 dargestellten Ausführungsbeispiel weist die Kathodenschicht 16 zusätzlich zu dem zweiten Schichtabschnitt 16.2 den Übergangsschichtabschnitt 16.3 auf.

Zwischen dem Driftgebiet 14 und dem zweiten Abschnitt 12.2 der Anodenschicht 12 ist als Teil der Anodenschicht 12 ein p-dotierter Übergangsschichtabschnitt 12.3 ausgebildet.

Die Dotierstoffkonzentration des Übergangsschichtabschnitt 12.3 der Anode nimmt entlang der Schichtdicke des Übergangschichtabschnitts 12.3 in Richtung des zweiten Abschnitts 12.2 der Anodenschicht 12 zu. Die Zunahme der Dotierung ist konkav oder konvex oder linear oder treppenförmig ausgebildet.

In der Abbildung der Figur 6 ist Dotierstoffkonzentrationsverlaufs für die in Zusammenhang mit der Figur 5 dargestellten Ausführungsform, abgebildet. Im Folgenden werden nur die Unterschiede zu der Ausführungsform der Figur 2 erläutert.

Der Deltaschichtabschnitt 16.1 der Kathodenschicht 16 ist auf einer von dem Driftgebiet 14 abgewandten Seite des zweiten Schichtabschnitts 16.2 angeordnet, so dass die Dotierstoffkonzentration entlang der Kathodenschicht in Richtung des Driftgebiets 14 sprunghaft abfällt.

Zwischen dem zweiten Abschnitt 16.2 der Kathodenschicht 16 und dem Driftgebiet 14 ist wiederum die Übergangsschichtabschnitt 16.3 als Teil der Kathodenschicht 16 ausgebildet.

Die Dotierstoffkonzentration nimmt der Übergangsschichtabschnitt 16.3 der Kathodenschicht 16 nimmt im weiteren Verlauf in Richtung des Driftgebiets 14 ab.

Zwischen dem Driftgebiet 14 und dem zweiten Abschnitt 12.2 der Anodenschicht 12 ist als Teil der Anodenschicht 12 ein p-dotierter Übergangsschichtabschnitt 12.3 ausgebildet. Die Dotierstoffkonzentration nimmt der Übergangsschichtabschnitt 12.3 der Anodenschicht 12 nimmt im weiteren Verlauf in Richtung des zweiten Abschnitts 12.2 der Anodenschicht 12 zu.

## Patentansprüche

1. Stapelförmige III-V-Halbleiterdiode (10) umfassend oder bestehend aus GaAs, aufweisend
- eine hoch n-dotierte Kathodenschicht (16),
- eine hoch p-dotierte Anodenschicht (12) und
- ein zwischen der Kathodenschicht (16) und der Anodenschicht (12) angeordnetes Driftgebiet (14) mit einer Dotierstoffkonzentration von höchstens 8●10¹⁵ cm⁻³ und einer Schichtdicke (D_{D}) von mindestens 10 µm und maximal 80 µm oder maximal 100 µm,
**dadurch gekennzeichnet, dass**
- die Kathodenschicht (16) einen ersten Abschnitt (16.1) und einen zweiten Abschnitt (16.2) aufweist und der erste Abschnitt als ein Deltaschichtabschnitt mit einer Schichtdicke (D_{K1}) zwischen 0,1 µm bis 1 µm oder von 0,1 µm bis 2 µm ausgebildet Ist und eine Dotierstoffkonzentration von mindestens 1●10¹⁹ cm⁻³ oder von mindestens 2●10¹⁹ cm⁻³ aufweist.

2. Stapelförmige III-V-Halbleiterdiode (10) nach Anspruch 1, **dadurch gekennzeichnet, dass** der Deltaschichtabschnitt (16.1) an eine metallische Kathodenkontaktschicht (M1) stoffschlüssig angrenzt.

3. Stapelförmige III-V-Halbleiterdiode (10) nach Anspruch 1 oder Anspruch 2, **dadurch gekennzeichnet, dass** der zweite Abschnitt (16.2) der Kathodenschicht (16) eine kleinere Dotierstoffkonzentration als der Deltaschichtabschnitt aufweist.

4. Stapelförmige III-V-Halbleiterdiode (10) nach einem der vorstehenden Ansprüche, **dadurch gekennzeichnet, dass** der zweite Abschnitt (16.2) der Kathodenschicht (16) eine Dotierstoffkonzentration von kleiner als 1●10¹⁹ cm⁻³ und oberhalb von 1●10¹⁸ cm⁻³ oder von 2●10¹⁸ cm⁻³ oder von 5●10¹⁸ cm⁻³ aufweist.

5. Stapelförmige III-V-Halbleiterdiode (10) nach einem der vorstehenden Ansprüche, **dadurch gekennzeichnet, dass** der zweite Abschnitt (16.2) der Kathodenschicht (16) eine Schichtdicke (D_{K2}) zwischen 0,5 µm bis 1,5 µm oder von zwischen 0,5 µm bis 2,5 µm auf oder zwischen 0,5 µm bis 5 µm aufweist.

6. Stapelförmige III-V-Halbleiterdiode (10) nach einem der vorstehenden Ansprüche, **dadurch gekennzeichnet, dass** die Kathodenschicht (16) einen Übergangsschichtabschnitt (16.3) aufweist, wobei der Übergangsschichtabschnitt (16.3) zwischen dem zweiten Abschnitt (16.2) und dem Driftgebiet (14) angeordnet ist, eine Schichtdicke (D_{K3}) von mindestens 3 µm aufweist und der Übergangsschichtabschnitt (16.3) eine geringere Dotierstoffkonzentration als der zweiten Abschnitt (16.2) und eine größere Dotierstoffkonzentration als das Driftgebiet (14) aufweist und der Verlauf der Dotierstoffkonzentration einen in Richtung des Driftgebiets (14) konvex oder konkav oder linear oder treppenförmig abfallenden Dotierstoffkonzentrationsverlauf aufweist.

7. Stapelförmige III-V-Halbleiterdiode (10) nach einem der vorstehenden Ansprüche, **dadurch gekennzeichnet, dass** die Anodenschicht (12) einen ersten Abschnitt (12.1) und einen zwischen dem ersten Abschnitt (12.1) und dem Driftgebiet (14) angeordneten zweiten Abschnitt (12.2) aufweist und eine Dotierstoffkonzentration des zweiten Abschnitts (12.2) kleiner ist als die Dotierstoffkonzentration des ersten Abschnitts (12.1) oder die Dotierstoffkonzentration des zweiten Abschnitts (12.2) gleich ist wie die Dotierstoffkonzentration des ersten Abschnitts (12.1).

8. Stapelförmige III-V-Halbleiterdiode (10) nach einem der vorstehenden Ansprüche, **dadurch gekennzeichnet, dass** die Dotierstoffkonzentration des ersten Abschnitts (12.1) der Anodenschicht (12) mindestens 8●10¹⁷ cm⁻³ und höchstens 4●10¹⁸ cm⁻³ oder höchstens 8●10¹⁸ cm⁻³ beträgt und die Dotierstoffkonzentration des zweiten Abschnitts der Anodenschicht (12) mindestens 1●10¹⁷ cm⁻³ und höchstens 8●10¹⁷ cm⁻³ beträgt.

9. Stapelförmige III-V-Halbleiterdiode (10) nach einem der vorstehenden Ansprüche, **dadurch gekennzeichnet, dass** die Anodenschicht (12) einen an das Driftgebiet (14) angrenzenden Übergangsabschnitt (12.3) aufweist, wobei der Übergangsabschnitt (12.3) einen in Richtung des Driftgebiets (14) konvex oder konkav oder linear oder treppenförmig abfallenden Dotierstoffkonzentrationsverlauf und ein Dotierstoffkonzentration größer als die Dotierstoffkonzentration des p-dotierten Driftgebiets und kleiner als die Dotierstoffkonzentration des zweiten Abschnitts (12.2) der Anodenschicht (12) ist.

10. Stapelförmige III-V-Halbleiterdiode (10) nach einem der vorstehenden Ansprüche, **dadurch gekennzeichnet, dass** der zweite Abschnitt (12.2) der Anodenschicht (12) eine kleinere Dotierung aufweist als der zweite Abschnitt der (16.2) der Kathodenschicht (16).

11. Stapelförmige III-V-Halbleiterdiode (10) nach einem der vorstehenden Ansprüche, dass der Deltaschichtabschnitt (16.1) Te oder Se als Dotierstoff aufweist.
